# EUROPEAN PATENT APPLICATION

(11) **EP 4 661 611 A1**
(43) Date of publication of application: **10.12.2025**
(21) Application number: 24769863.2
(22) Date of filing: 08.03.2024
(51) Int. Cl.: H05K 7/20

(54) **BOARD-LEVEL ARCHITECTURE AND ELECTRONIC DEVICE**

(30) Priority: 10.03.2023 CN 202310269320
(71) Applicant: Huawei Technologies Co., Ltd., Shenzhen, Guangdong 518129 (CN)
(72) Inventor: JIAO, Zelong, Shenzhen, Guangdong 518129 (CN); YANG, Chengpeng, Shenzhen, Guangdong 518129 (CN); ZHANG, Liang, Shenzhen, Guangdong 518129 (CN)
(74) Representative: Maiwald GmbH
(86) International application number: PCT/CN2024/080715
(87) International publication number: WO 2024/188170

(57) **Abstract**

The present disclosure discloses a board-level architecture and an electronic device, and pertains to the field of electronic device technologies. The board-level architecture includes a support plate, a first heat sink, a first circuit board, a first connection member, and a first buffer. The first heat sink and the support plate are disposed opposite to each other and are fastened to each other. The first circuit board is located between the first heat sink and the support plate. The first circuit board is connected to the first heat sink through the first connection member and can move toward or away from the first heat sink. A first heat generation component is on a side that is of the first circuit board and that is close to the first heat sink. The first heat generation component is thermally coupled to the first heat sink. The first buffer is configured to provide acting force for driving the first circuit board to move toward the first heat sink. The first circuit board can float relative to the first heat sink. In this way, when the electronic device falls or is subjected to external impact, relative movement can occur between the first circuit board and the first heat sink, to reduce impact on the first circuit board.

## Description

The present disclosure claims priority to Chinese Patent Application No. 202310269320.6, filed on March 10, 2023 and entitled "BOARD-LEVEL ARCHITECTURE AND ELECTRONIC DEVICE", which is incorporated herein by reference in its entirety.

### TECHNICAL FIELD

Embodiments of the present disclosure relate to the field of electronic device technologies, and in particular, to a board-level architecture and an electronic device.

### BACKGROUND

With gradual improvement of product performance, in an electronic device used in the communication field, the computer field, or the like, power consumption of a heat generation component such as a chip on a circuit board is increasingly high, and a requirement for heat dissipation is also increasingly high. To better dissipate heat from the heat generation component on the circuit board, a heat sink is disposed for a heat generation component generating a large amount of heat.

Inside the electronic device, a fireproof plate is usually disposed on a side of the circuit board, and the circuit board is fastened to the fireproof plate. The heat sink is disposed on a side that is of the circuit board and that is away from the fireproof plate, and is thermally coupled to the heat generation component. The heat sink can generally float relative to the circuit board. In other words, in a direction perpendicular to the circuit board, the heat sink can move relative to the circuit board within a specific range.

In a case such as a fall, when the electronic device is subjected to certain impact, relative movement occurs between the heat sink and the circuit board. The substantial mass of the heat sink exerts considerable force upon the heat generation component, affecting the thermal coupling between the heat sink and the heat generation component, diminishing cooling efficiency, and potentially causing damage to the heat generation component. The heat sink may also be skewed due to external force, affecting the thermal coupling between the heat sink and the heat generation component.

The present disclosure provides a board-level architecture and an electronic device, to prevent external impact or external force from affecting thermal coupling between a heat sink and a heat generation component. The technical solutions are as follows.

According to a first aspect, a board-level architecture is provided. The board-level architecture includes a support plate, a first heat sink, a first circuit board, a first connection member, and a first buffer. The first heat sink and the support plate are disposed opposite to each other and are fastened to each other. The first circuit board is located between the first heat sink and the support plate. The first circuit board is connected to the first heat sink through the first connection member and can move toward or away from the first heat sink. A first heat generation component is on a side that is of the first circuit board and that is close to the first heat sink. The first heat generation component is thermally coupled to the first heat sink. The first buffer is configured to provide acting force for driving the first circuit board to move toward the first heat sink.

Based on the foregoing structure, a gap is formed between the support plate and the first heat sink, the first circuit board is located in the gap, and the first circuit board can float relative to the first heat sink. In this way, when an electronic device falls or is subjected to external impact, relative movement can occur between the first circuit board and the first heat sink, to reduce impact on the first circuit board. The first buffer provides acting force for driving the first circuit board to move toward the first heat sink, so that the first circuit board can return to an original position after impact ends, to ensure that the first circuit board and the first heat sink keep in thermal coupling. In a process in which the electronic device falls or is subjected to external impact, although the first circuit board is still subjected to certain impact, due to small mass of the circuit board, the impact is much smaller than impact caused by the heat sink. This greatly reduces a possibility of damaging a thermal interface material, reduces a possibility of affecting heat dissipation effect, and also greatly reduces a possibility of damaging the heat generation component.

In some examples, the first connection member includes a plurality of first rod members, the plurality of first rod members are separately connected to the first heat sink, the first circuit board is provided with a plurality of first connection holes, the plurality of first connection holes are sleeved outside the plurality of first rod members respectively, and the first connection hole is in a clearance fit with the first rod member. The first rod member cooperates with the first connection hole to perform a limiting and guiding function, so that the first circuit board can move along the first rod member.

In an example, the first buffer includes a plurality of first elastic members, and the plurality of first elastic members are sleeved outside at least a part of the plurality of first rod members. The first elastic member is located between the first circuit board and the support plate and is in a compressed state, and the first elastic member further abuts against the first circuit board. The first elastic member in the compressed state applies elastic force to the first circuit board, and pushes the first circuit board toward the first heat sink, so that the first circuit board and the first heat sink keep in a good thermal coupling state.

In another example, the first buffer includes a plurality of first elastic members, and the plurality of first elastic members are sleeved outside at least a part of the plurality of first rod members. The first elastic member is located between the first circuit board and the first heat sink and is in a stretched state, and the first elastic member is further connected to the first circuit board. The first elastic member provides the first circuit board with pushing force pointing to a direction of the first heat sink.

In some examples, at least a part of the plurality of first rod members is connected to the support plate.

Based on the foregoing features, at least a part of the first rod members is connected to the support plate, and the support plate and the first heat sink are connected as a whole by using the first rod member, so that a fixed gap is maintained between the support plate and the first heat sink.

Optionally, the board-level architecture further includes a first limiting member. The first limiting member is located between the first heat sink and the first circuit board and is connected to the first rod member, and is used to limit a movement range of the first circuit board when the first circuit board moves toward the first heat sink, to avoid excessive pressing between the first circuit board and the first heat sink.

Optionally, the board-level architecture further includes a second limiting member, the second limiting member is located between the support plate and the first circuit board, and the second limiting member is connected to a first rod member connected to the support plate. The second limiting member may also constrain the first circuit board, and is used to limit a movement range of the first circuit board when the first circuit board moves away from the first heat sink.

In some examples, the first connection member includes a plurality of second rod members, the plurality of second rod members are connected to the first circuit board, the first heat sink is provided with a plurality of second connection holes, the plurality of second connection holes are sleeved outside the plurality of second rod members respectively, and the second connection hole is in a clearance fit with the second rod member. The second rod member cooperates with the second connection hole to perform a limiting and guiding function, so that the first circuit board and the second rod member as a whole can move along the second connection hole.

In some examples, the first buffer includes a plurality of second elastic members, and the plurality of second elastic members are sleeved outside at least a part of the plurality of second rod members. The plurality of second elastic members are located on a side that is of the first heat sink and that is away from the first circuit board and are in a compressed state, and the plurality of second elastic members further abut against the first heat sink. The second elastic member in the compressed state applies elastic force to the first heat sink, and pushes the first heat sink toward the first circuit board, so that the first circuit board and the first heat sink keep in a good thermal coupling state.

In some other examples, the first buffer includes a plurality of second elastic members, and the plurality of second elastic members are sleeved outside at least a part of the plurality of second rod members. The plurality of second elastic members are located on a side that is of the first heat sink and that is away from the first circuit board and are in a compressed state, and abut against the first heat sink; or the plurality of second elastic members are located between the first heat sink and the first circuit board and are in a stretched state, and the plurality of second elastic members are further connected to the first circuit board. The second elastic member provides, through the second rod member, the first circuit board with pulling force pointing to a direction of the first heat sink.

In an example, the board-level architecture further includes a second circuit board, a second connection member, and a second buffer. The second circuit board is located between the first heat sink and the support plate. The second circuit board is connected to the first heat sink through the second connection member and can move toward or away from the first heat sink. A second heat generation component is on a side that is of the second circuit board and that is close to the first heat sink. The second heat generation component is thermally coupled to the first heat sink. The second buffer is configured to provide acting force for driving the second circuit board to move toward the first heat sink.

Based on the foregoing features, each circuit board can float relative to the first heat sink. In a process in which the electronic device falls or is subjected to external impact, a possibility of damaging a thermal interface material between each circuit board and the first heat sink is reduced, a possibility of affecting heat dissipation effect is reduced, and a possibility of damaging a heat generation component on each circuit board is also reduced.

In some examples, the board-level architecture further includes a first flexible transmission member, and the first flexible transmission member connects the first circuit board to the second circuit board. Because the first flexible transmission member is flexible, movement of the first circuit board and the second circuit board is not affected.

In some examples, a third heat generation component is on a side that is of the first circuit board and that is close to the support plate. The board-level architecture further includes a second heat sink and a thermally conductive member, the second heat sink is located on the side that is of the first circuit board and that is close to the first heat sink and is connected to the first circuit board, orthographic projections of the second heat sink and the first heat sink onto a surface of the first circuit board do not overlap, the thermally conductive member is located on the side that is of the first circuit board and that is close to the support plate, and the thermally conductive member is thermally coupled to the third heat generation component and the second heat sink.

Based on the foregoing features, the thermally conductive member can conduct heat generated by the third heat generation component to the second heat sink, and the second heat sink dissipates heat, to improve heat dissipation effect.

In an example, the board-level architecture further includes a first connector and a second flexible transmission member, the first connector is connected to the support plate, and the second flexible transmission member connects the first connector to the first circuit board. The second flexible transmission member is used to connect the first connector to the first circuit board. In this way, normal signal transmission between the first connector and the first circuit board can be ensured without affecting floating of the first circuit board relative to the first heat sink.

In another example, the board-level architecture further includes a second connector, a third circuit board, and a third flexible transmission member, the second connector is connected to the third circuit board, at least one of the second connector and the third circuit board is connected to the support plate, and the third flexible transmission member connects the first circuit board to the third circuit board. The first circuit board and the third circuit board are equivalent to two independent circuit boards obtained by dividing one circuit board. In this way, the first circuit board can float relative to the first heat sink, and the third circuit board is prevented from affecting the first circuit board.

According to a second aspect, an electronic device is provided. The electronic device includes any board-level architecture according to the first aspect.

### BRIEF DESCRIPTION OF DRAWINGS

FIG. 1 is a diagram of a structure of a board-level architecture of an electronic device;
FIG. 2 is a diagram of an exploded structure of an example board-level architecture according to an embodiment of the present disclosure;
FIG. 3 is a diagram of a side-view structure of a first example board-level architecture according to an embodiment of the present disclosure;
FIG. 4 is a diagram of a side-view structure of a second example board-level architecture according to an embodiment of the present disclosure;
FIG. 5 is a diagram of a side-view structure of a third example board-level architecture according to an embodiment of the present disclosure;
FIG. 6 is a diagram of a side-view structure of a fourth example board-level architecture according to an embodiment of the present disclosure;
FIG. 7 is a diagram of a side-view structure of a fifth example board-level architecture according to an embodiment of the present disclosure;
FIG. 8 is a diagram of a side-view structure of a sixth example board-level architecture according to an embodiment of the present disclosure;
FIG. 9 is a diagram of a side-view structure of a seventh example board-level architecture according to an embodiment of the present disclosure;
FIG. 10 is a diagram of a side-view structure of an eighth example board-level architecture according to an embodiment of the present disclosure;
FIG. 11 is a diagram of a side-view structure of a ninth example board-level architecture according to an embodiment of the present disclosure; and
FIG. 12 is a diagram of a side-view structure of a tenth example board-level architecture according to an embodiment of the present disclosure.

### Reference numerals:

In related technologies:
1: fireproof plate; 2: heat sink; 3: circuit board; 4: connector; 5: heat generation component;
In the present disclosure:
10: support plate; 20: first heat sink; 20a: second connection hole; 20b: indentation; 201: boss;
30: first circuit board; 30a: first connection hole; 31: first heat generation component; 32: third heat generation component; 311: fixed connection member;
321: second heat sink; 322: thermally conductive member; 3221: thermally conductive substrate; 3222: heat pipe; 33: first connector; 34: second connector; 341: third circuit board;
40: first connection member; 41: first rod member; 42: second rod member; 411: first stopper;
50: first buffer; 51: first elastic member; 52: second elastic member;
61: first limiting member; 62: second limiting member;
70: second circuit board; 71: second heat generation component;
80: second connection member; 421: second stopper;
90: second buffer;
101: first flexible transmission member; 102: second flexible transmission member; 103: third flexible transmission member.

### DESCRIPTION OF EMBODIMENTS

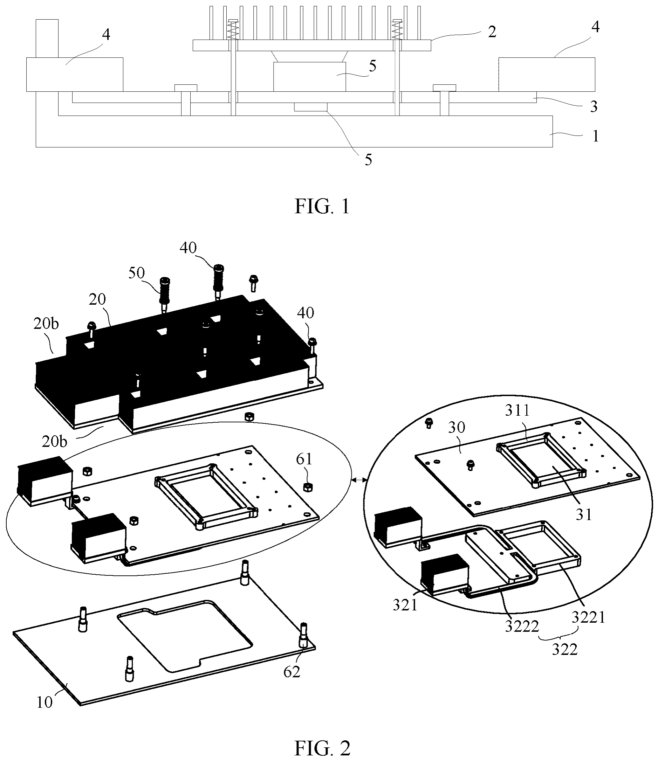

FIG. 1 is a diagram of a structure of a board-level architecture of an electronic device. As shown in FIG. 1, the board-level architecture includes a fireproof plate 1, a heat sink 2, and a circuit board 3. The circuit board 3 is connected to the fireproof plate 1 through a screw. A connector 4 is connected to the circuit board 3, and the connector 4 is connected to the fireproof plate 1. Some heat generation components 5 may be distributed on both sides of the circuit board 3. A heat generation component 5 on a side that is of the circuit board 3 and that is close to the fireproof plate 1 dissipates heat naturally, or is in contact with the fireproof plate 1 and dissipates heat by using the fireproof plate 1. A heat generation component 5 on a side that is of the circuit board 3 and that is away from the fireproof plate 1 dissipates heat by using the heat sink 2. A thermal interface material (thermal interface material, TIM) is usually disposed between the heat sink 2 and the heat generation component 5. The thermal interface material can be accommodated in an air gap between the heat generation component 5 and the heat sink 2, so that heat generated by the heat generation component 5 is conducted to the heat sink 2 more quickly. The heat sink 2 is not in fixed connection to the circuit board 3. The heat sink 2 can float relative to the circuit board 3, and keep in contact with the heat generation component 5 under an action of a spring.

When the electronic device falls or is subjected to external impact, relative displacement may occur between the heat sink 2 and the circuit board 3, and the heat sink 2 may generate impact on the circuit board 3. The substantial mass of the heat sink 2 exerts considerable force and may damage integrity of the thermal interface material, diminishing cooling efficiency, and even causing damage to the heat generation component 5 in contact with the heat sink 2.

FIG. 2 is a diagram of an exploded structure of a board-level architecture according to an embodiment of the present disclosure. As shown in FIG. 2, the board-level architecture includes a support plate 10, a first heat sink 20, a first circuit board 30, a first connection member 40, and a first buffer 50.

The support plate 10 may be a fireproof plate. The fireproof plate can prevent fire caused by excessively high temperature of a heat generation component on the first circuit board 30, and can be used as a mounting foundation to mount a structure other than the support plate.

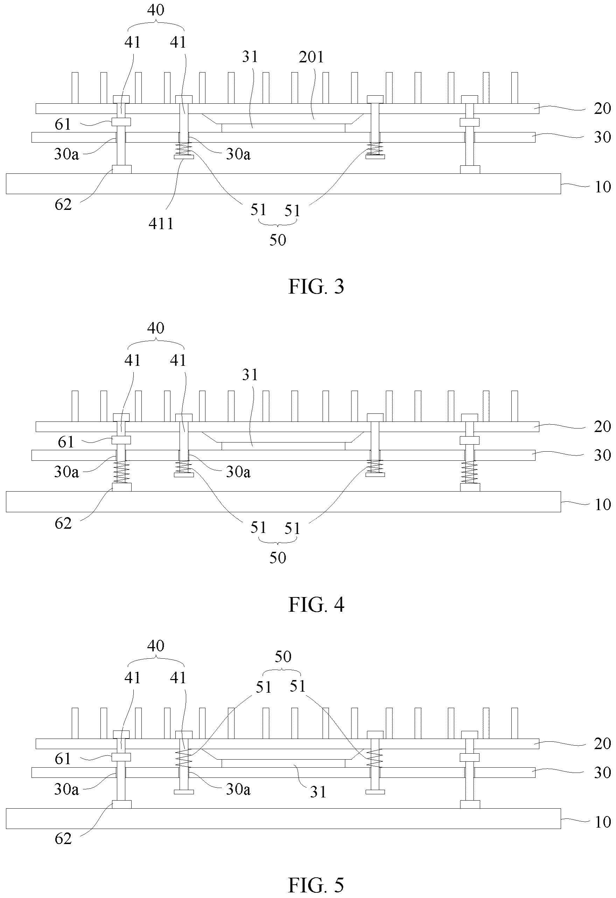

FIG. 3 is a diagram of a side-view structure of a board-level architecture according to an embodiment of the present disclosure. As shown in FIG. 3, a first heat sink 20 and a support plate 10 are disposed opposite to each other, and the first heat sink 20 and the support plate 10 are fastened to each other. A distance between the first heat sink 20 and the support plate 10 remains unchanged due to the mutual fastening, and there is a gap with a constant width between the first heat sink 20 and the support plate 10, to accommodate a structure such as a first circuit board 30.

Fins are distributed on a surface of the first heat sink 20, and the fins may be distributed on one or more surfaces of the first heat sink 20. For example, the fins may be distributed on a surface that is of the first heat sink 20 and that is away from the support plate 10, or may be distributed on a surface that is of the first heat sink 20 and that is close to the support plate 10, or the fins are distributed on both the surface of the first heat sink 20 close to the support plate 10 and the surface away from the support plate 10.

As shown in FIG. 3, the first circuit board 30 is located between the first heat sink 20 and the support plate 10. The first circuit board 30 is connected to the first heat sink 20 through a first connection member 40, and the first circuit board 30 can move toward or away from the first heat sink 20. A first heat generation component 31 is on a side that is of the first circuit board 30 and that is close to the first heat sink 20, and the first heat generation component 31 is thermally coupled to the first heat sink 20.

The thermal coupling herein includes but is not limited to that the first heat generation component 31 is in direct contact with the first heat sink 20 to implement heat transfer, or that a thermal interface material is accommodated between the first heat generation component 31 and the first heat sink 20 to implement heat transfer.

For example, as shown in FIG. 3, a boss 201 is on a side that is of the first heat sink 20 and that is close to the first circuit board 30, the boss 201 is opposite to the first heat generation component 31, and a thermal interface material is accommodated in a gap between the boss 201 and the first heat generation component 31.

A first buffer 50 is configured to provide acting force for driving the first circuit board 30 to move toward the first heat sink 20. For example, in FIG. 3, the first buffer 50 is located on a side that is of the first circuit board 30 and that is close to the support plate 10, and provides the first circuit board 30 with acting force pointing to the first heat sink 20, to drive the first circuit board 30 to move toward an upper part shown in FIG. 3.

The first heat sink 20 and the support plate 10 are fastened to each other, to form a gap between the first heat sink 20 and the support plate 10. The first circuit board 30 is located in the gap between the first heat sink 20 and the support plate 10, and the first circuit board 30 can move toward or away from the first heat sink 20. In other words, the first circuit board 30 can float relative to the first heat sink 20. In this way, when an electronic device falls or is subjected to external impact, relative movement can occur between the first circuit board 30 and the first heat sink 20, to reduce impact on the first circuit board 30. The first buffer 50 provides acting force for driving the first circuit board 30 to move toward the first heat sink 20, so that the first circuit board 30 can return to an original position after impact ends, to ensure that the first circuit board 30 and the first heat sink 20 keep in thermal coupling. In a process in which the electronic device falls or is subjected to external impact, although the first circuit board 30 is still subjected to certain impact, due to small mass of the circuit board, the impact is much smaller than impact caused by the heat sink. This greatly reduces a possibility of damaging the thermal interface material, reduces a possibility of affecting heat dissipation effect, and also greatly reduces a possibility of damaging the heat generation component.

The first buffer 50 may be a component that can provide elastic force, such as a spring or a spring sheet. A spring is used as an example for description in embodiments of the present disclosure. The first buffer 50 may be located on the first connection member 40, and the first connection member 40 is used to provide specific support for the first buffer 50.

In the example shown in FIG. 3, the first connection member 40 includes a plurality of first rod members 41, and the plurality of first rod members 41 are separately connected to the first heat sink 20. The first circuit board 30 is provided with a plurality of first connection holes 30a, the plurality of first connection holes 30a are sleeved outside the plurality of first rod members 41 respectively, and the first connection hole 30a is in a clearance fit with the first rod member 41.

The first rod member 41 is in fixed connection to the first heat sink 20, so that the first rod member 41 remains stable. The first rod member 41 cooperates with the first connection hole 30a to perform a limiting and guiding function, so that the first circuit board 30 can move along the first rod member 41.

The plurality of first rod members 41 may be distributed around the first heat generation component 31 to improve stability, so that the first circuit board 30 is more stable when moving, to prevent the first circuit board 30 from tilting.

As shown in FIG. 3, at least a part of the plurality of first rod members 41 is connected to the support plate 10.

At least a part of the first rod members 41 is connected to the support plate 10, and the support plate 10 and the first heat sink 20 are connected as a whole by using the first rod member 41, so that a fixed gap is maintained between the support plate 10 and the first heat sink 20. In some examples, alternatively, all the first rod members 41 may be connected to the support plate 10.

For example, the first rod member 41 may be a bolt, and the first rod member 41 may be in a thread fit with the first heat sink 20 and the support plate 10, to facilitate connection and disassembly.

As shown in FIG. 3, the first buffer 50 includes a plurality of first elastic members 51, and the plurality of first elastic members 51 are sleeved outside at least a part of the plurality of first rod members 41.

Certainly, in some examples, alternatively, a first elastic member 51 may be sleeved outside each first rod member 41, for example, as shown in FIG. 4. A quantity of disposed first elastic members 51 may depend on a required total magnitude of elastic force.

The plurality of first elastic members 51 may be distributed around the first heat generation component 31. In this way, acting force applied by the plurality of first elastic members 51 to the first circuit board 30 is more balanced, so that movement of the first circuit board 30 is more stable.

In this example, the first elastic member 51 is located between the first circuit board 30 and the support plate 10. The first elastic member 51 is in a compressed state, and the first elastic member 51 abuts against the first circuit board 30.

The first elastic member 51 in the compressed state applies elastic force to the first circuit board 30, and pushes the first circuit board 30 toward the first heat sink 20, so that the first circuit board 30 and the first heat sink 20 keep in a good thermal coupling state.

As shown in FIG. 3, the first elastic member 51 is a spring and has two opposite ends, one end of the first elastic member 51 abuts against the first circuit board 30, and the other end of the first elastic member 51 may be constrained by using the first rod member 41.

In an example, as shown in FIG. 3, the first connection member 40 may further include a first stopper 411, the first stopper 411 is connected to the first rod member 41, one end of the first elastic member 51 abuts against the first circuit board 30, and the other end of the first elastic member 51 abuts against the first stopper 411.

For example, the first stopper 411 may be but is not limited to a circlip or a nut. The first stopper 411 may be in thread connection to the first rod member 41. This can facilitate adjustment of a position of the first stopper 411 on the first rod member 41, to adjust a magnitude of elastic force that can be provided by the first elastic member 51.

Separate adjustment of a magnitude of elastic force applied by each first elastic member 51 enables an appropriate magnitude of acting force of mutual pressing between the first heat generation component 31 and the first heat sink 20, and enables more balanced acting force applied by the plurality of first elastic members 51 to the first circuit board 30, so that the first circuit board 30 is more stable. When the first rod member 41 is a bolt, the first stopper 411 may alternatively be a bolt head, and the first elastic member 51 may abut against the bolt head of the bolt.

As shown in FIG. 3, the board-level architecture further includes a first limiting member 61. The first limiting member 61 is located between the first heat sink 20 and the first circuit board 30. The first limiting member 61 is connected to the first rod member 41.

The first limiting member 61 may constrain the first circuit board 30, and is used to limit a movement range of the first circuit board 30 when the first circuit board 30 moves toward the first heat sink 20, to avoid excessive pressing between the first circuit board 30 and the first heat sink 20.

The first rod member 41 may be disposed on any first rod member 41. The first rod members 41 include a first rod member connected to the first heat sink 20 and a first rod member connected to both the first heat sink 20 and the support plate 10. The first limiting member 61 may be disposed on the first rod member 41 connected to the first heat sink 20, or may be disposed on the first rod member 41 connected to both the first heat sink 20 and the support plate 10. The plurality of first elastic members 51 are sleeved outside a part or all of the plurality of first rod members 41. The first limiting member 61 may be disposed on the first rod member 41 with the first elastic member 51, or may be disposed on the first rod member 41 without the first elastic member 51.

In some examples, a position of the first limiting member 61 on the first rod member 41 is adjustable, so that the movement range of the first circuit board 30 can be changed by adjusting the position of the first limiting member 61 on the first rod member 41.

For example, the first limiting member 61 is in thread connection to the first rod member 41. For example, the first limiting member 61 may be but is not limited to a circlip or a nut.

As shown in FIG. 3, the board-level architecture further includes a second limiting member 62. The second limiting member 62 is located between the support plate 10 and the first circuit board 30. The second limiting member 62 is connected to a first rod member 41 connected to the support plate 10.

The second limiting member 62 may also constrain the first circuit board 30, and is used to limit a movement range of the first circuit board 30 when the first circuit board 30 moves away from the first heat sink 20.

In addition, the second limiting member 62 is located on the first rod member 41 connected to the support plate 10, and can be further used to raise the first circuit board 30. Components may be disposed on both sides of the circuit board. For example, a component may be further disposed on the side that is of the first circuit board 30 and that is close to the support plate 10. A half of the component on the circuit board protrudes from a surface of the circuit board. The first circuit board 30 is raised by the second limiting member 62, to prevent the component on the surface of the circuit board from being pressed by the support plate 10 and damaged during movement of the first circuit board 30.

In an example, the second limiting member 62 is in fixed connection to the support plate 10, and the second limiting member 62 is further connected to the first rod member 41, so that the second limiting member 62 is used to connect the first rod member 41 to the support plate 10. For example, the second limiting member 62 may be a connection column that is in fixed connection to the support plate 10, and the connection column may be tubular.

In some examples, a position of the second limiting member 62 on the first rod member 41 is adjustable, so that the movement range of the first circuit board 30 can be changed by adjusting the position of the second limiting member 62 on the first rod member 41, and the first circuit board 30 is raised to an appropriate position relative to the support plate 10.

For example, the second limiting member 62 is in thread connection to the first rod member 41. For example, the second limiting member 62 may be but is not limited to a circlip or a nut.

FIG. 5 is a diagram of a side-view structure of a board-level architecture according to an embodiment of the present disclosure. A difference between the board-level architecture and that shown in FIG. 3 mainly lies in disposing of a first elastic member 51. As shown in FIG. 5, in this example, the first elastic member 51 is located between a first circuit board 30 and a first heat sink 20. The first elastic member 51 is in a stretched state, and the first elastic member 51 is connected to the first circuit board 30.

In the example shown in FIG. 3, the first elastic member 51 is located on a side that is of the first circuit board 30 and that is away from the first heat sink 20, and the first elastic member 51 provides the first circuit board 30 with pushing force pointing to a direction of the first heat sink 20. In the example shown in FIG. 5, the first elastic member 51 is located on a side that is of the first circuit board 30 and that is close to the first heat sink 20, and the first elastic member 51 provides the first circuit board 30 with pulling force pointing to a direction of the first heat sink 20.

In the example shown in FIG. 5, an end of the first elastic member 51 is connected to the first circuit board 30, and another end of the first elastic member 51 is connected to the first heat sink 20. In another example, the another end of the first elastic member 51 may alternatively be fastened to a first rod member 41 and connected to the first rod member 41.

In some examples, a reinforcement structure may be further disposed on a surface of the first circuit board 30. For example, the reinforcement structure may be a gasket. The reinforcement structure may be located on two sides of the first circuit board 30, and the reinforcement structure may be annular and disposed around a first connection hole 30a. The reinforcement structure is configured to strengthen an area around the first connection hole 30a of the first circuit board 30, and bear acting force during contact with a first limiting member 61 or a second limiting member 62, or bear acting force during contact with the first elastic member 51. This helps prolong a service life and further improves reliability of the board-level architecture.

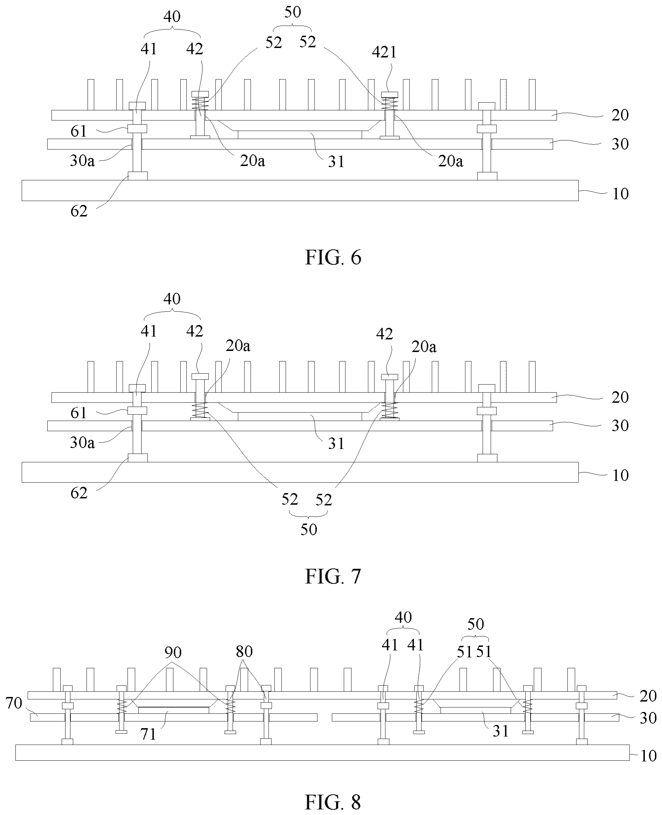

FIG. 6 is a diagram of a side-view structure of a board-level architecture according to an embodiment of the present disclosure. As shown in FIG. 6, in this example, a first connection member 40 includes a plurality of second rod members 42, and the plurality of second rod members 42 are connected to a first circuit board 30. A first heat sink 20 is provided with a plurality of second connection holes 20a, the plurality of second connection holes 20a are sleeved outside the plurality of second rod members 42 respectively, and the second connection hole 20a is in a clearance fit with the second rod member 42.

The second rod member 42 is in fixed connection to the first circuit board 30, so that the second rod member 42 remains stable. The second rod member 42 cooperates with the second connection hole 20a to perform a limiting and guiding function, so that the first circuit board 30 and the second rod member 42 as a whole can move along the second connection hole 20a.

The first connection member 40 may include a plurality of rod members, and the first connection member 40 may include at least one of a first rod member 41 and a second rod member 42. The first rod member 41 is in a clearance fit with a first connection hole 30a of the first circuit board 30, and the second rod member 42 is in a clearance fit with a second connection hole 20a of the first heat sink 20. In this example, the first connection member 40 includes a plurality of first rod members 41 and a plurality of second rod members 42. In the example shown in FIG. 6, all the first rod members 41 are connected to the support plate 10, to limit a movement direction of the first circuit board 30. In another example, alternatively, only a part of the first rod members 41 may be connected to the support plate 10.

As shown in FIG. 6, a first limiting member 61 and a second limiting member 62 are further disposed on the first rod member 41, to limit a movement range of the first circuit board 30. For specific descriptions of the first limiting member 61 and the second limiting member 62, refer to the board-level architecture shown in FIG. 3 to FIG. 5.

As shown in FIG. 6, a first buffer 50 includes a plurality of second elastic members 52, and the plurality of second elastic members 52 are sleeved outside at least a part of the plurality of second rod members 42.

Certainly, in some examples, alternatively, a second elastic member 52 may be sleeved outside each second rod member 42, for example, as shown in FIG. 6. A quantity of disposed second elastic members 52 may depend on a required total magnitude of elastic force.

The plurality of second elastic members 52 may be distributed around a first heat generation component 31. In this way, acting force applied by the plurality of second elastic members 52 to the first circuit board 30 is more balanced, so that movement of the first circuit board 30 is more stable.

The first buffer 50 may include a plurality of first elastic members 51 and/or a plurality of second elastic members 52. In other words, the first buffer 50 includes at least one of a first elastic member 51 and a second elastic member 52. The first elastic member 51 is sleeved outside the first rod member 41, and the second elastic member 52 is sleeved outside the second rod member 42.

The second elastic member 52 can also provide acting force for driving the first circuit board 30 to move toward the first heat sink 20. In this example, the plurality of second elastic members 52 are located on a side that is of the first heat sink 20 and that is away from the first circuit board 30. The plurality of second elastic members 52 are in a compressed state, and the second elastic members 52 abut against the first heat sink 20.

The second elastic member 52 in the compressed state applies elastic force to the first heat sink 20, and pushes the first heat sink 20 toward the first circuit board 30, so that the first circuit board 30 and the first heat sink 20 keep in a good thermal coupling state.

As shown in FIG. 6, the second elastic member 52 may also be a spring, an end of the first elastic member 51 abuts against the first heat sink 20, and another end of the second elastic member 52 may be constrained by using the second rod member 42. For example, when the second rod member 42 is a bolt, the another end of the second elastic member 52 may abut against a bolt head of the bolt. The second elastic member 52 pushes the first heat sink 20 toward the first circuit board 30, that is, raises the second rod member 42 away from the support plate 10. The second rod member 42 is in fixed connection to the first circuit board 30, so that the first circuit board 30 moves toward the first heat sink 20.

In an example, a second connection member 80 may further include a second stopper 421, the second stopper 421 is connected to the second rod member 42, an end of the second elastic member 52 abuts against the first heat sink 20, and another end of the second elastic member 52 abuts against the second stopper 421.

For example, the second stopper 421 may be but is not limited to a circlip or a nut. The second stopper 421 may be in thread connection to the second rod member 42. This can facilitate adjustment of a position of the second stopper 421 on the second rod member 42, to adjust a magnitude of elastic force that can be provided by the second elastic member 52. Separate adjustment of a magnitude of elastic force applied by each second elastic member 52 enables an appropriate magnitude of acting force of mutual pressing between the first heat generation component 31 and the first heat sink 20, and enables more balanced acting force applied by the plurality of second elastic members 52 to the first heat sink 20, so that the first circuit board 30 is more stable.

FIG. 7 is a diagram of a side-view structure of a board-level architecture according to an embodiment of the present disclosure. A difference between the board-level architecture and that shown in FIG. 6 mainly lies in disposing of a second elastic member 52. As shown in FIG. 7, in this example, a plurality of second elastic members 52 are located between a first circuit board 30 and a first heat sink 20. The second elastic member 52 is in a stretched state, and is connected to the first circuit board 30.

In the example shown in FIG. 6, the second elastic member 52 is located on the side that is of the first heat sink 20 and that is away from the first circuit board 30, and the second elastic member 52 provides, through the second rod member 42, the first circuit board 30 with pulling force pointing to a direction of the first heat sink 20. In the example shown in FIG. 7, the second elastic member 52 is located on a side that is of the first circuit board 30 and that is close to the first heat sink 20, and the second elastic member 52 directly applies, to the first circuit board 30, pulling force pointing to a direction of the first heat sink 20.

In the example shown in FIG. 7, an end of the second elastic member 52 is connected to the first circuit board 30, and another end of the second elastic member 52 is connected to the first heat sink 20. In another example, alternatively, an end of the second elastic member 52 may be connected to a first rod member 41, and another end may be connected to the first heat sink 20.

Optionally, a fixed connection member 311 may be further disposed on the first circuit board 30. As shown in FIG. 2, the fixed connection member 311 may be located on the side that is of the first circuit board 30 and that is close to the first heat sink 20. A second rod member 42 may be connected to the fixed connection member 311.

For example, the fixed connection member 311 may be of a rectangular frame structure, and the fixed connection member 311 may be disposed around a first heat generation component 31. This can facilitate connection to the second rod member 42, and can protect the first heat generation component 31 to some extent.

FIG. 8 is a diagram of a side-view structure of a board-level architecture according to an embodiment of the present disclosure. As shown in FIG. 8, the board-level architecture further includes a second circuit board 70, a second connection member 80, and a second buffer 90.

The second circuit board 70 is located between a first heat sink 20 and a support plate 10, the second circuit board 70 is connected to the first heat sink 20 through the second connection member 80, and the second circuit board 70 can move toward or away from the first heat sink 20. A second heat generation component 71 is on a side that is of the second circuit board 70 and that is close to the first heat sink 20, and the second heat generation component 71 is thermally coupled to the first heat sink 20.

The second buffer 90 is configured to provide acting force for driving the second circuit board 70 to move toward the first heat sink 20. For example, in FIG. 8, the second buffer 90 is located on a side that is of the second circuit board 70 and that is away from the support plate 10, and provides the second circuit board 70 with acting force pointing to the first heat sink 20, to drive the second circuit board 70 to move toward an upper part shown in FIG. 8.

In this embodiment of the present disclosure, the second circuit board 70 is a circuit board other than a first circuit board 30 in the board-level architecture. For a structure and an arrangement of the second connection member 80, refer to the structure and the arrangement of the foregoing first connection member 40. For a structure and an arrangement of the second buffer 90, refer to the structure and the arrangement of the foregoing first buffer 50. In some board-level architectures, a plurality of circuit boards may be disposed, all of which are equipped with heat generation components that necessitate heat dissipation. A connection member and a buffer are disposed for each circuit board, so that each circuit board can float relative to a first heat sink 20. In a process in which an electronic device falls or is subjected to external impact, a possibility of damaging a thermal interface material between each circuit board and the first heat sink 20 is reduced, a possibility of affecting heat dissipation effect is reduced, and a possibility of damaging a heat generation component on each circuit board is also reduced.

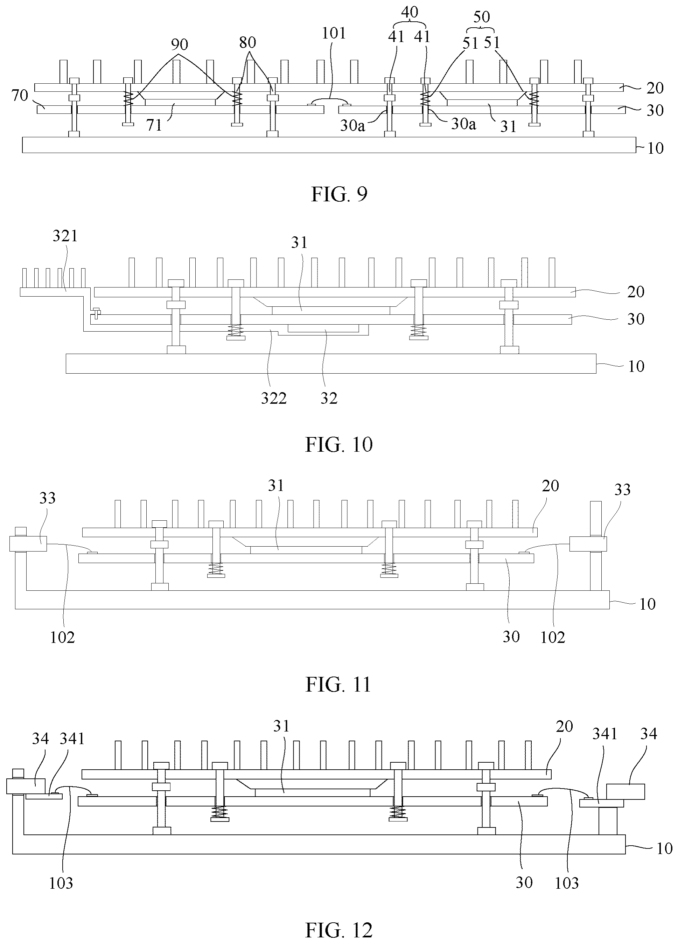

FIG. 9 is a diagram of a side-view structure of a board-level architecture according to an embodiment of the present disclosure. In comparison with the board-level architecture shown in FIG. 8, as shown in FIG. 9, in this example, the board-level architecture further includes a first flexible transmission member 101. The first flexible transmission member 101 connects a first circuit board 30 to a second circuit board 70.

Unidirectional or bidirectional signal transmission may need to be performed between different circuit boards. The first flexible transmission member 101 is used to connect the first circuit board 30 to the second circuit board 70, so that a signal can be transmitted between the two circuit boards through the first flexible transmission member 101. Because the first flexible transmission member 101 is flexible, movement of the first circuit board 30 and the second circuit board 70 is not affected. In a process in which an electronic device falls or is subjected to impact, both the first circuit board 30 and the second circuit board 70 can float relative to a first heat sink 20 to be not affected by the impact, and the first circuit board 30 and the second circuit board 70 do not affect each other.

In an example, the first flexible transmission member 101 may include a flexible circuit board. In another example, the first flexible transmission member 101 may further include a cable, for example, a conducting wire or a data cable. Different cables may be selected according to different signals that need to be transmitted. In addition, the first flexible transmission member 101 may further include an optical cable, to implement transmission of an optical signal.

FIG. 10 is a diagram of a side-view structure of a board-level architecture according to an embodiment of the present disclosure. In comparison with the board-level architecture shown in FIG. 3 to FIG. 9, in FIG. 10, a third heat generation component 32 is on a side that is of a first circuit board 30 and that is close to a support plate 10. Heat generation components may be disposed on both sides of the circuit board, and a heat generation component close to the support plate 10 is poor in heat dissipation.

In this embodiment of the present disclosure, the board-level architecture further includes a second heat sink 321 and a thermally conductive member 322, and the second heat sink 321 is configured to dissipate heat from a heat generation component on the side that is of the circuit board and that is close to the support plate 10.

As shown in FIG. 10, the second heat sink 321 is located on a side that is of the first circuit board 30 and that is close to a first heat sink 20, and the second heat sink 321 is connected to the first circuit board 30. Orthographic projections of the second heat sink 321 and the first heat sink 20 onto a surface of the first circuit board 30 do not overlap. The thermally conductive member 322 is located on the side that is of the first circuit board 30 and that is close to the support plate 10, and the thermally conductive member 322 is thermally coupled to the third heat generation component 32 and the second heat sink 321.

The thermally conductive member 322 can conduct heat generated by the third heat generation component 32 to the second heat sink 321, and the second heat sink 321 dissipates heat, to improve heat dissipation effect. In this way, a component with higher power may be disposed on the side that is of the first circuit board 30 and that is close to the support plate 10. This helps further improve performance of an electronic device.

As shown in FIG. 2, there are two indentations 20b in a corner of the first heat sink 20. The indentations 20b may be configured to accommodate the second heat sink 321, so that the orthographic projections of the second heat sink 321 and the first heat sink 20 onto the surface of the first circuit board 30 do not overlap, and both the first heat sink 20 and the second heat sink 321 can better dissipate heat.

In an example, the second heat sink 321 may be connected to an edge of the first circuit board 30 through a screw.

As shown in FIG. 2, the thermally conductive member 322 may include a thermally conductive substrate 3221 and a heat pipe 3222, and the thermally conductive substrate 3221 is connected to the second heat sink 321 through the heat pipe 3222.

With reference to FIG. 2 and FIG. 10, there may be a depression at a middle part of the thermally conductive substrate 3221, and the thermally conductive substrate 3221 covers the third heat generation component 32. A thermal interface material may be accommodated between the thermally conductive substrate 3221 and the third heat generation component 32.

FIG. 11 is a diagram of a side-view structure of a board-level architecture according to an embodiment of the present disclosure. As shown in FIG. 11, the board-level architecture further includes a first connector 33 and a second flexible transmission member 102. The first connector 33 is connected to a support plate 10, and the second flexible transmission member 102 connects the first connector 33 to a first circuit board 30.

A connector is a structure used for the circuit board to be connected to another electronic component. The connector is usually in direct fixed connection to the circuit board, and the connector extends out from an insertion opening provided on the support plate 10. The connector is usually in fixed connection to the support plate 10 at the insertion opening. Such an arrangement inevitably affects floating of the circuit board. In this embodiment of the present disclosure, the first connector 33 is connected to the support plate 10, and the second flexible transmission member 102 is used to connect the first connector 33 to the first circuit board 30. In this way, normal signal transmission between the first connector 33 and the first circuit board 30 can be ensured without affecting floating of the first circuit board 30 relative to the first heat sink 20.

FIG. 12 is a diagram of a side-view structure of a board-level architecture according to an embodiment of the present disclosure. As shown in FIG. 12, the board-level architecture further includes a second connector 34, a third circuit board 341, and a third flexible transmission member 103. The second connector 34 is connected to the third circuit board 341, at least one of the second connector 34 and the third circuit board 341 is connected to a support plate 10, and the third flexible transmission member 103 connects a first circuit board 30 to the third circuit board 341.

In the example shown in FIG. 12, the first circuit board 30 is a circuit board on which a first heat generation component 31 is located, and the first circuit board 30 dissipates heat by using a first heat sink 20. The third circuit board 341 is connected to the support plate 10, or is connected to the support plate 10 through the second connector 34. The first circuit board 30 and the third circuit board 341 are equivalent to two independent circuit boards obtained by dividing one circuit board. In this way, the first circuit board 30 can float relative to the first heat sink 20, and the third circuit board 341 is prevented from affecting the first circuit board 30.

In an example, both a second flexible transmission member 102 and the third flexible transmission member 103 may include a flexible circuit board. In another example, the second flexible transmission member 102 and the third flexible transmission member 103 may further include a cable, for example, a conducting wire or a data cable. Different cables may be selected according to different signals that need to be transmitted. In addition, the second flexible transmission member 102 and the third flexible transmission member 103 may further include an optical cable, to implement transmission of an optical signal. A first connector 33 and the second connector 34 may be disposed according to a signal that needs to be transmitted. For example, the first connector 33 and the second connector 34 may be electrical connectors or optical connectors.

An embodiment of the present disclosure further provides an electronic device. The electronic device includes any board-level architecture shown in FIG. 1 to FIG. 12.

For example, the electronic device provided in this embodiment of the present disclosure includes but is not limited to a network communication device, a computing device, and the like.

Terms used in implementations of the present disclosure are merely used to explain embodiments of the present disclosure, but are not intended to limit the present disclosure. Unless otherwise defined, technical terms or scientific terms used in implementations of the present disclosure should have the common meanings understood by a person of ordinary skill in the art to which the present disclosure pertains.

"First", "second", "third", and the like used in the specification and claims of the present disclosure are not intended to indicate any order, quantity, or significance, but are merely used for distinguishing between different components. Similarly, "a/an", "one", or the like is not intended to indicate a quantity limitation, but is intended to indicate existence of at least one. "Include", "comprise", or the like means that an element or object before "include" or "comprise" encompasses elements or objects and their equivalents listed after "include" or "comprise", and other elements or objects are not excluded. "Connection", "link", or the like is not limited to physical or mechanical connection, but may include electrical connection, whether direct or indirect. "Up", "down", "left", "right", or the like is merely intended to indicate a relative positional relationship. When an absolute position of an object described changes, the relative positional relationship may also change accordingly.

The foregoing descriptions are merely intended to help a person skilled in the art understand the technical solutions of the present disclosure, and are not intended to limit the present disclosure. Any modification, equivalent replacement, or improvement made without departing from the spirit and principle of the present disclosure shall fall within the protection scope of the present disclosure.

## Claims

1. A board-level architecture, wherein the board-level architecture comprises a support plate (10), a first heat sink (20), a first circuit board (30), a first connection member (40), and a first buffer (50);
the first heat sink (20) and the support plate (10) are disposed opposite to each other and are fastened to each other;
the first circuit board (30) is located between the first heat sink (20) and the support plate (10), the first circuit board (30) is connected to the first heat sink (20) through the first connection member (40) and is capable of moving toward or away from the first heat sink (20), a first heat generation component (31) is on a side that is of the first circuit board (30) and that is close to the first heat sink (20), and the first heat generation component (31) is thermally coupled to the first heat sink (20); and
the first buffer (50) is configured to provide acting force for driving the first circuit board (30) to move toward the first heat sink (20).

2. The board-level architecture according to claim 1, wherein the first connection member (40) comprises a plurality of first rod members (41), and the plurality of first rod members (41) are separately connected to the first heat sink (20); and
the first circuit board (30) is provided with a plurality of first connection holes (30a), the plurality of first connection holes (30a) are sleeved outside the plurality of first rod members (41) respectively, and the first connection hole (30a) is in a clearance fit with the first rod member (41).

3. The board-level architecture according to claim 2, wherein the first buffer (50) comprises a plurality of first elastic members (51), and the plurality of first elastic members (51) are sleeved outside at least a part of the plurality of first rod members (41), wherein
the first elastic member (51) is located between the first circuit board (30) and the support plate (10) and is in a compressed state, and the first elastic member (51) further abuts against the first circuit board (30); or
the first elastic member (51) is located between the first circuit board (30) and the first heat sink (20) and is in a stretched state, and the first elastic member (51) is further connected to the first circuit board (30).

4. The board-level architecture according to claim 2 or 3, wherein at least a part of the plurality of first rod members (41) is connected to the support plate (10).

5. The board-level architecture according to claim 4, wherein the board-level architecture further comprises a first limiting member (61), the first limiting member (61) is located between the first heat sink (20) and the first circuit board (30), and the first limiting member (61) is connected to the first rod member (41).

6. The board-level architecture according to claim 5, wherein the board-level architecture further comprises a second limiting member (62), the second limiting member (62) is located between the support plate (10) and the first circuit board (30), and the second limiting member (62) is connected to a first rod member (41) connected to the support plate (10).

7. The board-level architecture according to any one of claims 1 to 6, wherein the first connection member (40) comprises a plurality of second rod members (42), and the plurality of second rod members (42) are connected to the first circuit board (30); and
the first heat sink (20) is provided with a plurality of second connection holes (20a), the plurality of second connection holes (20a) are sleeved outside the plurality of second rod members (42) respectively, and the second connection hole (20a) is in a clearance fit with the second rod member (42).

8. The board-level architecture according to claim 7, wherein the first buffer (50) comprises a plurality of second elastic members (52), and the plurality of second elastic members (52) are sleeved outside at least a part of the plurality of second rod members (42), wherein
the plurality of second elastic members (52) are located on a side that is of the first heat sink (20) and that is away from the first circuit board (30) and are in a compressed state, and the plurality of second elastic members (52) further abut against the first heat sink (20); or
the plurality of second elastic members (52) are located between the first heat sink (20) and the first circuit board (30) and are in a stretched state, and the plurality of second elastic members (52) are further connected to the first circuit board (30).

9. The board-level architecture according to any one of claims 1 to 8, wherein the board-level architecture further comprises a second circuit board (70), a second connection member (80), and a second buffer (90);
the second circuit board (70) is located between the first heat sink (20) and the support plate (10), the second circuit board (70) is connected to the first heat sink (20) through the second connection member (80) and is capable of moving toward or away from the first heat sink (20), a second heat generation component (71) is on a side that is of the second circuit board (70) and that is close to the first heat sink (20), and the second heat generation component (71) is thermally coupled to the first heat sink (20); and
the second buffer (90) is configured to provide acting force for driving the second circuit board (70) to move toward the first heat sink (20).

10. The board-level architecture according to claim 9, wherein the board-level architecture further comprises a first flexible transmission member (101), and the first flexible transmission member (101) connects the first circuit board (30) to the second circuit board (70).

11. The board-level architecture according to any one of claims 1 to 10, wherein a third heat generation component (32) is on a side that is of the first circuit board (30) and that is close to the support plate (10); and
the board-level architecture further comprises a second heat sink (321) and a thermally conductive member (322), the second heat sink (321) is located on the side that is of the first circuit board (30) and that is close to the first heat sink (20) and is connected to the first circuit board (30), orthographic projections of the second heat sink (321) and the first heat sink (20) onto a surface of the first circuit board (30) do not overlap, the thermally conductive member (322) is located on the side that is of the first circuit board (30) and that is close to the support plate (10), and the thermally conductive member (322) is thermally coupled to the third heat generation component (32) and the second heat sink (321).

12. The board-level architecture according to any one of claims 1 to 11, wherein the board-level architecture further comprises a first connector (33) and a second flexible transmission member (102), the first connector (33) is connected to the support plate (10), and the second flexible transmission member (102) connects the first connector (33) to the first circuit board (30).

13. The board-level architecture according to any one of claims 1 to 12, wherein the board-level architecture further comprises a second connector (34), a third circuit board (341), and a third flexible transmission member (103), the second connector (34) is connected to the third circuit board (341), at least one of the second connector (34) and the third circuit board (341) is connected to the support plate (10), and the third flexible transmission member (103) connects the first circuit board (30) to the third circuit board (341).

14. An electronic device, wherein the electronic device comprises the board-level architecture according to any one of claims 1 to 13.
